# DEMANDE DE BREVET EUROPEEN

(11) **EP 1 331 837 A1**
(43) Date de publication de la demande: **30.07.2003**
(21) Numéro de dépôt: 03290118.3
(22) Date de dépôt: 17.01.2003
(51) Int. Cl.: H05K 7/02, H01R 9/24

(54) **Boîte d'interconnexion**

(30) Priorité: 18.01.2002 FR 0200623
(71) Demandeur: Valeo Electronique et Systemes de Liaison, 78180 Montigny le Bretonneux (FR)
(72) Inventeur: Devauchelle, Guillaume, 78180 Montigny le Bretonneux (FR); Vercelli, Bruno, 78990 Elancourt (FR)
(74) Mandataire: Faber, Jean-Paul

(57) **Abrégé**

Boîte d'interconnexion comprenant un corps en matière isolante (1), une série de circuits électriques, une série de composants électriques comportant des languettes (14) enfichables dans des fentes (10, 10a) pour coopérer avec des organes de contact électrique (20) reliés aux circuits électriques et logés dans des canaux (15) dans lesquels débouchent les fentes (10, 10a), caractérisée en ce qu'elle comporte, une série de tiges (32) bonne conductrice de l'électricité non isolée et constituant les différents circuits électriques, lesdites tiges (32) étant pliées de manière, d'une part, à pouvoir se chevaucher sans de toucher et, d'autre part, à présenter au moins une boucle (37) destinée à s'insérer dans un canal (15) correspondant et à coopérer avec les organes de contact électrique (20).

## Description

La présente invention vise une boîte d'interconnexion, telle qu'une boîte à fusibles.

Généralement, pour réaliser des boîtes d'interconnexion, on utilise différentes techniques.

Une de ces techniques consiste à réaliser les câblages avec des circuits imprimés auxquels sont reliés les composants électriques. Cette technique présente l'inconvénient d'être coûteuse.

Une autre technique consiste à découper, dans des feuilles métalliques, des pistes qui sont ensuite emprisonnées dans des épaisseurs de matière plastique et qui constituent les circuits électriques ; cette technique présente l'inconvénient de nécessiter un outillage impliquant un certain investissement et se prête mal à des modifications.

Enfin, on peut réaliser le câblage avec des conducteurs souples isolés dont les extrémités dénudées sont soudées aux composants. Une telle technique nécessite une main d'oeuvre importante ce qui grève le prix de revient.

L'un des buts de la présente invention est de réaliser une boîte d'interconnexion qui remédie aux inconvénients ci-dessus.

La boîte d'interconnexion, selon l'invention, est du type comprenant un corps en matière isolante présentant une embase avec une face supérieure et une face inférieure, une série de circuits électriques, une série de composants électriques tels que relais, fusibles etc. comportant des languettes enfichables dans des fentes de l'embase pour coopérer avec des organes de contact électrique reliés aux circuits électriques et logés dans des canaux dans lesquels débouchent les fentes, ladite boîte d'interconnexion étant caractérisée en ce qu'elle comporte, du côté de sa face inférieure non isolée, une série de tiges bonnes conductrices de l'électricité et constituant les différents circuits électriques, lesdites tiges étant pliées de manière, d'une part, à pouvoir se chevaucher sans se toucher et, d'autre part, à présenter au moins une boucle destinée à s'insérer dans un canal correspondant et à coopérer avec les organes de contact électrique.

Grâce à cette disposition, on peut, avec une machine très simple, découper à la longueur désirée les tiges, plier celles-ci afin qu'elles puissent chevaucher d'autres tiges sans les toucher et former la ou les boucles destinées à s'insérer dans les canaux.

Suivant une caractéristique de détail, la boîte d'interconnexion comporte au moins un logement dans lequel débouchent les extrémités de tiges qui constituent des broches de connecteurs électriques.

Afin que les tiges ne puissent pas se déplacer intempestivement, l'embase comporte, sur sa face inférieure, des pattes élastiques de maintien des tiges.

Suivant une caractéristique de détail, la face supérieure de l'embase comporte un logement dans lequel débouchent des languettes qui sont prolongées du côté de la face inférieure de l'embase par deux ailes délimitant une cavité destinée à recevoir, engagée à force, une tige.

Enfin, suivant encore une caractéristique de détail, la face inférieure de l'embase comporte deux pattes de fixation d'un élément de boîtier dans lequel débouchent les extrémités de tiges pour former un élément de connecteur.

L'invention va maintenant être décrite avec plus de détails en se référant à un mode de réalisation particulier donné à titre d'exemple seulement et représenté aux dessins annexés.

Figure 1 est une vue en perspective d'une boîte d'interconnexion, selon l'invention.

Figure 2 est une vue en perspective par-dessous de la boite d'interconnexion de la figure 1.

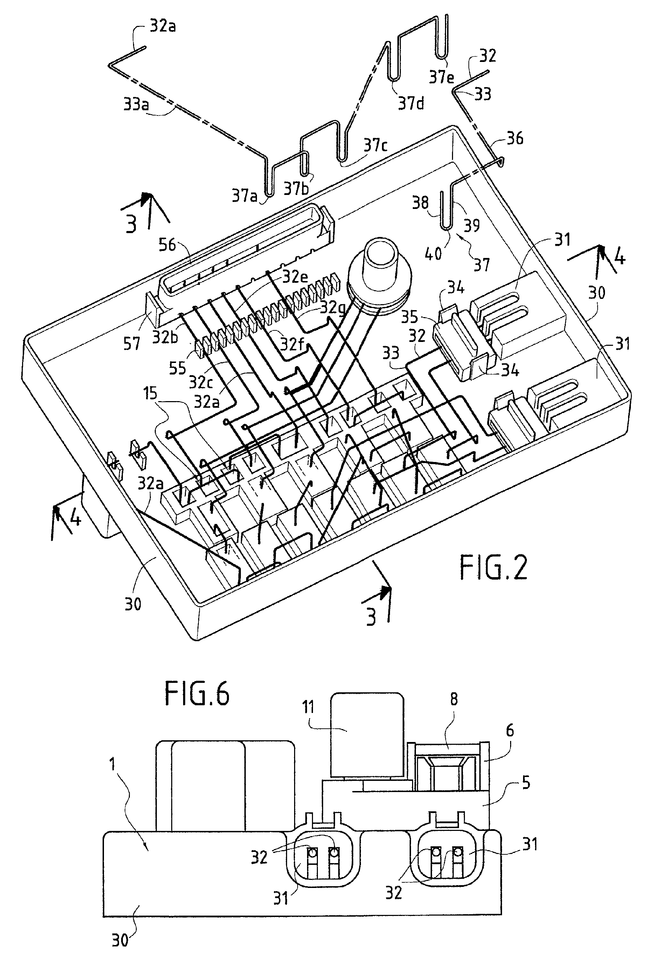

Figue 3 est une vue en coupe suivant la ligne 3-3 de la figure 2.

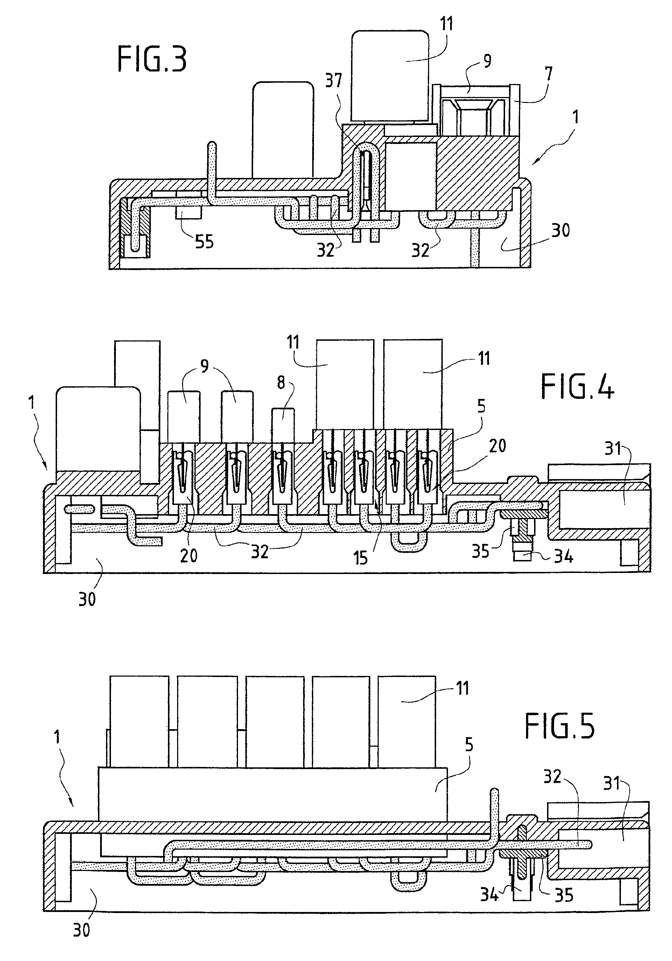

Figure 4 est une vue en coupe suivant la ligne 4-4 de la figure 2.

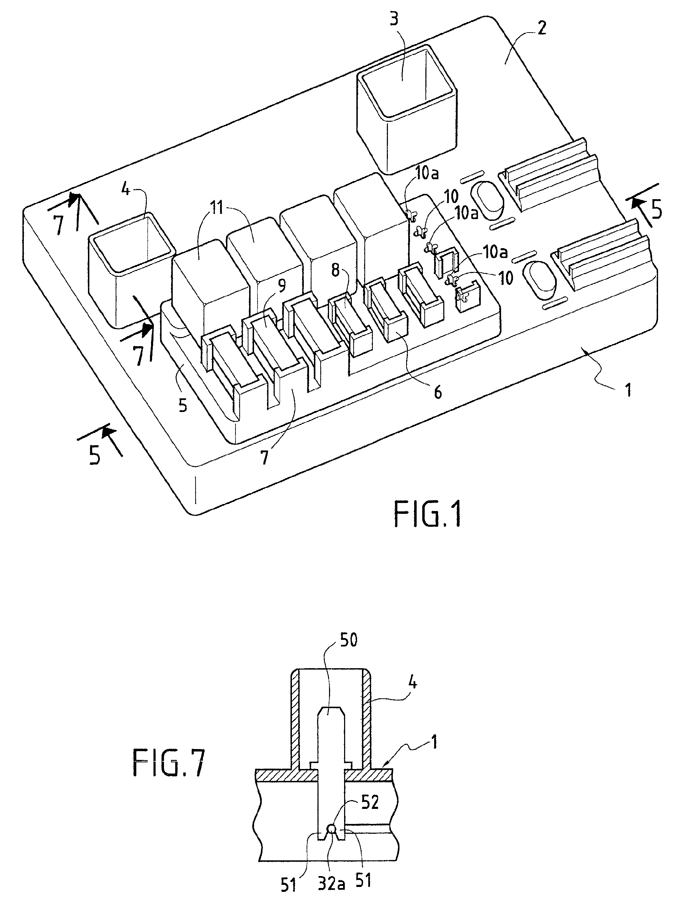

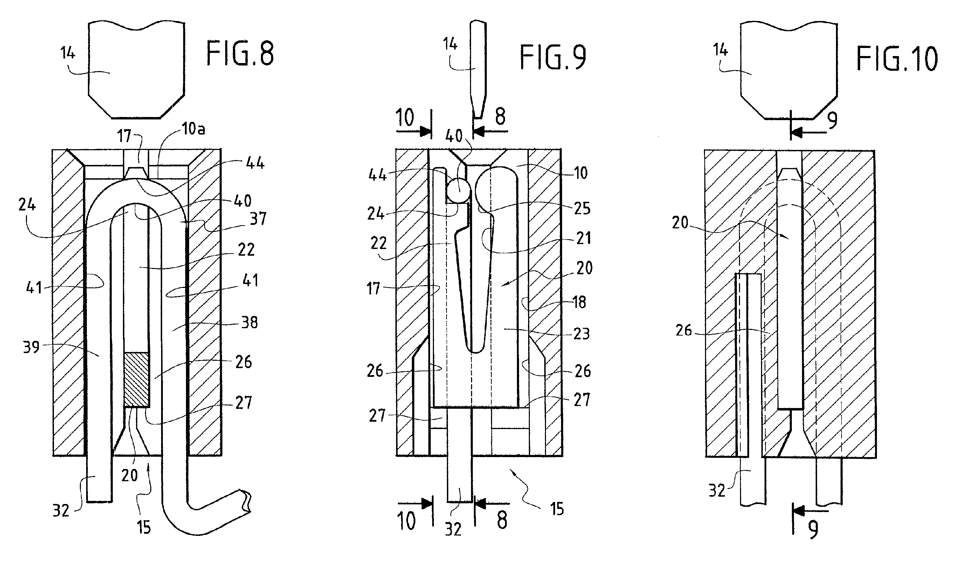

Figure 5 est une vue en coupe suivant la ligne 5-5 de la figure 1.

Figure 6 est une vue en élévation de face.

Figure 7 est une vue en coupe suivant la ligne 7-7 de la figure 1.

Figure 8 est une vue en coupe suivant la ligne 8-8 de la figure 9.

Figure 9 est une vue en coupe suivant la ligne 9-9 de la figure 10.

Figure 10 est une vue en coupe suivant la ligne 10-10 de la figure 9.
La boîte d'interconnexion représentée aux figures est réalisée en matière plastique moulée et comprend un corps 1 avec une embase 2 présentant, sur sa face supérieure, une surface en saillie 5.

A partir de l'embase 2 s'étendent deux logements 3 et 4 destinés à recevoir des fiches.

La surface en saillie 5 comporte deux séries de réceptacles 6 et 7 dans lesquels sont pratiquées des fentes 10, 10a destinées à recevoir des languettes 14 de fusibles 8 et 9.

La surface 5 présente, également des séries de fentes 10, 10a pour recevoir les languettes 14 de relais 11.

Les figures 8, 9 et 10 montrent en coupe les canaux 15 dans lesquels débouchent les fentes 10 ou 10a.

Chaque canal 15 comporte sur deux parois opposées des rainures 17 et 18 qui débouchent dans les fentes 10 et qui sont destinées à recevoir un organe de contact électrique 20 se présentant sous la forme d'une pince découpée dans un flan d'un alliage cuivreux bon conducteur de l'électricité et affectant une forme générale rectangulaire dans un des petits côtés duquel est découpé un ajour 21 délimitant deux branches 22 et 23, la branche 22, au voisinage de son extrémité libre, présentant un épaulement 24, tandis que la branche 23 est terminée, sur son bord tourné en regard de l'autre branche, par un bossage 25.

Dans chaque canal 15 sont conformées deux languettes de verrouillage 26 présentant des crochets 27 destinés à coopérer avec la pince 20 pour bloquer celle-ci dans les rainures.

Le corps 1 (voir figure 2), sur sa face inférieure, est bordé par un rebord 30 et présente deux logements 31 s'ouvrant sur un côté et constituant des prises femelles et dans lesquelles débouchent les extrémités de deux tiges 32 qui constituent des broches.

Les tiges 32 sont en un métal bon conducteur de l'électricité, sont rigides et pliées de manière à former un premier coude 33, un second coude 36 et sont terminées par une partie pliée en forme de boucle en épingle à cheveux 37 avec deux branches 38 et 39 reliées par une âme 40.

Chaque canal 15 (voir figure 8) comporte deux rainures 41 qui sont situées dans un plan perpendiculaire à celui dans lequel sont situées les rainures 17 et 18 et qui sont destinées à recevoir les boucles 37, les fentes 10 présentant des butées 44 de retenue de l'âme 40 de la boucle 37.

Les boucles 37 se trouvent ainsi bloquées entre les épaulements 24 et les butées 44 de retenue, tandis que les pinces 20 sont coincées entre les crochets 27 et les âmes 40.

Les languettes 14 des fusibles ou des relais sont introduites entre les branches 21 et 22 et ayant une épaisseur légèrement supérieure à la distance séparant la boucle 37 du bossage 25, ladite languette est pressée fortement contre ladite boucle afin d'assurer une bonne liaison électrique.

Les tiges 32 sont maintenues dans leur partie débouchant dans les logements 31 par des inserts 35 fixés par des pattes élastiques 34 s'érigeant à la surface de la face inférieure de l'embase 2 du corps 1.

Le logement 4 est destiné à recevoir une fiche mâle pourvue d'organes femelles de contact électrique, celle-ci pouvant, par exemple, être reliée à une source d'alimentation.

Dans le logement 4 (voir figure 7) débouchent deux languettes 50 solidaires du corps 1 et prolongées du côté de la face inférieure de l'embase 2 par deux ailes 51 délimitant une cavité circulaire 52 à entrée rétrécie afin de pouvoir engager à force et souder une tige 32a prolongée par un coude 33a et formant une succession de boucles 37a, 37b, 37c, 37d et 37e.

Les boucles 37a, 37b et 37c sont insérées dans différents canaux 15 correspondant à l'une des fentes 10, 10a destinées à recevoir l'une des languettes 14 des trois fusibles 9, dans ces canaux étant bien entendu insérées les pinces 20, tandis que les boucles 37d et 37e sont engagées dans les canaux 15 destinés à recevoir l'une des languettes de deux relais 11, ces canaux 15 recevant des pinces 20.

Comme on le voit sur les figures, il est prévu une série de tiges 32 qui permettent les liaisons électriques avec lesdits composants et l'alimentation de ceux-ci. Les tiges 32 sont pliées de manière à présenter des boucles 37 destinées à s'insérer dans les canaux 15 correspondants et à coopérer, chacune, avec une pince 20 destinée à recevoir une languette correspondante 14.

Les tiges 32 sont pliées préalablement à la pose afin qu'elles puissent se chevaucher sans se toucher.

Un certain nombre de tiges 32b à 32g sont fixées par des pattes élastiques 55 et s'insèrent, par leur extrémité libre, dans un élément de boîtier 56 fixé par des pattes élastiques 57 afin de constituer un élément de boîtier d'un connecteur susceptible de recevoir un élément de boîtier complémentaire relié, par exemple, à un circuit imprimé.

On conçoit que la réalisation des circuits électriques dans une telle boîte d'interconnexion est simple à mettre en oeuvre et qu'il est très aisé de modifier les circuits à partir d'un corps standard puisqu'il suffit de réaliser de simples tiges 32 ayant des formes différentes.

Bien entendu, l'invention n'est pas limitée au mode de réalisation qui vient d'être décrit et représenté. On pourra y apporter de nombreuses modifications de détail sans sortir pour cela du cadre de l'invention.

## Revendications

1. Boîte d'interconnexion du type comprenant un corps en matière isolante (1) présentant une embase (2) avec une face supérieure et une face inférieure, une série de circuits électriques, une série de composants électriques tels que relais, fusibles, etc. comportant des languettes (14) enfichables dans des fentes (10, 10a) de l'embase pour coopérer avec des organes de contact électrique reliés aux circuits électriques et logés dans des canaux (15) dans lesquels débouchent les fentes (10, 10a), **caractérisée en ce qu'**elle comporte, du côté de sa face inférieure, une série de tiges (32) bonne conductrice de l'électricité non isolée et constituant les différents circuits électriques, lesdites tiges (32) étant pliées de manière, d'une part, à pouvoir se chevaucher sans de toucher et, d'autre part, à présenter au moins une boucle (37) destinée à s'insérer dans un canal (15) correspondant et à coopérer avec les organes de contact électrique (20).

2. Boîte d'interconnexion, selon la revendication 1, **caractérisée en ce qu'**elle comporte, au moins, un logement (31) dans lequel débouchent les extrémités de tiges (32) qui constituent des broches de connecteurs électriques.

3. Boîte d'interconnexion, selon la revendication 1, **caractérisée en ce que** l'embase (2) comporte, sur sa face inférieure, des pattes élastiques (55) de maintien des tiges (32).

4. Boîte d'interconnexion, selon la revendication 1, **caractérisée en ce que** la face supérieure de l'embase (2) comporte un logement (4) dans lequel débouchent des languettes 50 qui sont prolongées du côté de la face inférieure de l'embase (2) par deux ailes (51) délimitant une cavité (52) destinée à recevoir, engagée à force, une tige (32).

5. Boîte d'interconnexion, selon la revendication 1, **caractérisée en ce que** la face inférieure de l'embase (2) comporte deux pattes de fixation (57) d'un élément de boîtier (56) dans lequel débouchent les extrémités de tiges (32) pour former un élément de connecteur.
